# EUROPEAN PATENT SPECIFICATION

(11) **EP 2 952 070 B1**
(45) Date of publication and mention of the grant of the patent: **30.05.2018**
(21) Application number: 14745537.2
(22) Date of filing: 04.02.2014
(51) Int. Cl.: H01J 37/147, H01J 37/317, H05H 3/02

(54) **METHOD AND APPARATUS FOR DIRECTING A NEUTRAL BEAM**
VERFAHREN UND VORRICHTUNG ZUR LENKUNG EINES NEUTRALEN STRAHLES
MÉTHODE ET APPAREIL POUR DIRIGER UN FAISCEAU NEUTRE

(30) Priority: 04.02.2013 US 201361760238 P
(43) Date of publication of application: 09.12.2015
(73) Proprietor: Exogenesis Corporation, Billerica, Massachusetts 01821 (US); Kirkpatrick, Sean, R., Billerica, MA 01821 (US); Chau, Son, Billerica, MA 01821 (US)
(72) Inventor: KIRKPATRICK, Sean, R., Billerica, MA 01821 (US); CHAU, Son, Billerica, MA 01821 (US)
(74) Representative: FRKelly
(86) International application number: PCT/US2014/014720
(87) International publication number: WO 2014/121285

(56) References cited:
- JP-A- H11 185 647
- US-A- 3 308 323
- US-A- 4 775 789
- US-A- 4 935 623
- US-A1- 2006 113 493
- US-A1- 2012 045 615
- US-A1- 2012 045 615

## Description

### FIELD OF THE INVENTION

This invention relates generally to a method and apparatus for steering or directing a neutral beam in a neutral beam processing tool or other apparatus. More specifically, it relates to steering, directing or aligning an accelerated Neutral Beam derived from an accelerated gas-cluster ion-beam (GCIB). The Neutral Beam is preferably an accelerated neutral monomer beam derived from a GCIB.

### BACKGROUND OF THE INVENTION

Ions have long been favored for use in many processes because their electric charge facilitates their manipulation by electrostatic and magnetic fields. This introduces great flexibility in processing. However, in some applications, the charge that is inherent to any ion (including gas-cluster ions in a GCIB) may produce undesirable effects in the processed surfaces, GCIB has a distinct advantage over conventional ion beams in that a gas-cluster ion with a single or small multiple charge enables the transport and control of a much larger mass-now (a cluster may consist of hundreds or thousands of molecules) compared to a conventional ion (an ionized single atom, molecule, or molecular fragment.) Particularly in the case of insulating materials, surfaces processed using ions often suffer from charge-induced damage resulting from abrupt discharge of accumulated charges, or production of damaging electrical field-induced stress in the material (again resulting from accumulated charges.) In many such cases, GCIBs have an advantage due to their relatively low charge per mass, but in some instances may not eliminate the target-charging problem. Furthermore, moderate to high current intensity ion beams may suffer from a significant space charge-induced defocusing of the beam that tends to inhibit transporting a well-focused beam over long distances. Again, due to their lower charge per mass relative to conventional ion beams, GCIBs have an advantage, but they do not fully eliminate the space charge beam transport problem.

Some methods and apparatus for generating Neutral Beams derived from accelerated GCIBs and a wide range of applications for such beams are taught in the commonly held US Patent Publication US 2012-0045615 A1.

Neutral Beams derived from accelerated GCIBs completely avoid the problems that result from transport of charges to the workpiece as well as the problems related to transporting charged beams over long distances. However, a difficulty in working with neutral beams is that they are not readily manipulated by electrostatic and magnetic fields. Thus, processes such as beam alignment, beam centering, and beam scanning are much more difficult to remedy when neutral beams are employed. Often minor misalignments of the initial gas-cluster jet from which a Neutral Beam may be generated through neutralization of an accelerated GCIB can result in a Neutral Beam that is not well aligned with the beamline and workpiece. Even when the initial beam is well aligned through careful design or adjustment, small changes in the positioning or alignment of downstream beamline elements as may arise during routine equipment cleaning or other maintenance can result in misalignment which is difficult to remedy because of the relative difficulty of manipulating a neutral beam.

With ion beams, deflection and scanning of the beam is readily achieved using electrostatic or magnetic deflectors and scanning elements in the beamline. Neutral Beams have heretofore been limited to using mechanical scanning of the workpiece through the stationary beam in order to achieve uniform scanning of workpieces larger than the beam dimensions.

It is therefore an object of this invention to provide methods and apparatus for correcting angular misalignment of a Neutral Beam derived from a GCIB.

It is another object of this invention to provide methods and apparatus for introducing a deflection of a Neutral Beam derived from a GCIB.

It is a further object of this invention to provide methods and apparatus for scanning a Neutral Beam derived from a GCIB relative to a workpiece or other object.

United States Patent specification No. US 2012/045615 - A1 discloses an apparatus, method and products thereof provide an accelerated neutral beam derived from an accelerated gas cluster ion beam for processing materials.

Japanese Patent specification No. JP H11 185647 discloses a suppressor electrode, an earth electrode and a suppressor region plate which can be individually position-adjusted by drive devices, and the longitudinal interval, vertical position, lateral position and tilt angle are adjusted in the ion beam advancing direction. A feedback control mechanism receives current values from a suppressing current measuring device and an ion beam current measuring device respectively and receives the position information of an extracting electrode system from an extracting electrode system control mechanism, and it calculates the position adjustment quantity and direction based on the input information and feeds-back them to the extracting electrode system control mechanism to suppress a suppressing current value to the minimum and to obtain the aimed ion beam current quantity, thereby the life of the extracting electrode system is extended.

### SUMMARY OF THE INVENTION

According to an aspect of the present invention, there is provided an apparatus for controlling and aligning a direction of a Neutral Beam derived from a gas-cluster ion-beam as specified in Claim 1. Further embodiments of the apparatus according to the invention are specified in any of Claims 2 - 5. According to a further aspect of the present invention, there is provided a method for producing a deflection and alignment of a Neutral Beam as specified in Claim 6. Further embodiments of the method according to the invention are specified in any of Claims 7 - 11. In forming a Neutral Beam, a conventional GCIB is generated, and subsequently the gas-cluster ions are accelerated to desired energy. The accelerated gas-cluster ions are subsequently dissociated or partially dissociated using non-contaminating methods into neutral particles and charged particles. The neutral particles may be neutral clusters and/or neutral monomers, preferably neutral monomers. Following dissociation, the original charges that formed the gas-cluster ions are removed from the beam, leaving an accelerated neutral beam that has been shown to be superior for many workpiece processing requirements.

During the acceleration of the gas-cluster ions and before the majority of the dissociation that provides the neutral particles, the beam is essentially a gas-cluster ion-beam that can be manipulated by electrostatic fields. By manipulating the beam electrostatically during that period, before conversion to a Neutral Beam, the trajectory of the ions can be influenced to provide alignment, deflection, or scanning. The trajectories thus formed become the subsequent trajectories of the Neutral Beam derived from the GCIB following dissociation and separation of the charged portions.

The trajectory changes thus provided give a means of correction for angular misalignments of the initial GCIB or neutral gas jet, providing deflections to the Neutral Beam, and/or providing scanning of the Neutral Beam.

As used herein, the terms "GCIB", "gas-cluster ion-beam" and "gas-cluster ion" are intended to encompass not only ionized beams and ions, but also accelerated beams and ions that have had a portion of their charge states modified (including neutralized) following their acceleration. The terms "GCIB" and "gas-cluster ion-beam" are intended to encompass all beams that comprise accelerated gas-cluster ions even though they may also comprise non-clustered particles. As used herein, the term "Neutral Beam" is intended to mean a beam of neutral gas clusters and/or neutral monomers derived from an accelerated gas-cluster ion-beam and wherein the acceleration results from acceleration of a gas-cluster ion-beam. As used herein, the term "monomer" refers equally to either a single atom or a single molecule. The terms "atom," "molecule," and "monomer" may be used interchangeably and all refer to the appropriate monomer that is characteristic of the gas under discussion (either a component of a cluster, a component of a cluster ion, or an atom or molecule). For example, a monatomic gas like argon may be referred to in terms of atoms, molecules, or monomers and each of those terms means a single atom. Likewise, in the case of a diatomic gas like nitrogen, it may be referred to in terms of atoms, molecules, or monomers, each term meaning a diatomic molecule. Furthermore a molecular gas like CH₄, may be referred to in terms of atoms, molecules, or monomers, each term meaning a five atom molecule, and so forth. These conventions are used to simplify generic discussions of gases and gas clusters or gas-cluster ions independent of whether they are monatomic, diatomic, or molecular in their gaseous form.

One embodiment of the invention provides an apparatus for controlling a direction and alignment of a Neutral Beam as defined in the appended claims 1-5. The accelerating electrode may be spaced from the exit aperture sufficiently to allow tilting of the accelerating electrode.

Another embodiment of the present invention provides a method for producing a deflection and alignment of a Neutral Beam as defined in appended claims 6 to 11. Again, the accelerating electrode may be spaced from the exit aperture sufficiently to allow tilting of the accelerating electrode. The first and second tilt axes may be perpendicular to each other and to the initial path. The method may further comprise the step of variably controlling the first and second tilt angles to produce a scanned Neutral Beam scanned in two dimensions.

### BRIEF DESCRIPTION OF THE DRAWINGS

Figure 1 is a schematic illustrating elements of a GCIB processing apparatus 1100 for processing a workpiece using a GCIB;
Figure 2 is a schematic illustrating elements of another GCIB processing apparatus 1200 for workpiece processing using a GCIB, wherein scanning of the ion beam and manipulation of the workpiece is employed;
Figure 3 is a schematic of a Neutral Beam processing apparatus 1300, which uses electrostatic deflection plates to separate the charged and uncharged beams;
Figure 4 is a schematic of a Neutral Beam processing apparatus 1400 using a thermal sensor for Neutral Beam measurement;
Figure 5 is a schematic of a simplified Neutral Beam processing apparatus 1500 according to an embodiment of the invention;
Figure 6 is a schematic 600 illustrating a concept underlying embodiments of the invention to permit mechanical steering of the Neutral Beam;
Figures 7A and 7B are two orthogonal views of a tiltable ground electrode assembly 700 for use in an embodiment of the invention; and
Figure 8 is a schematic of a Neutral Beam processing apparatus 1550 as may be employed in embodiments of the invention.

### DETAILED DESCRIPTION OF THE PREFERRED METHODS AND EXEMPLARY EMBODIMENTS

Beams of energetic conventional ions, accelerated electrically charged atoms or molecules, are widely utilized to form semiconductor device junctions, to modify surfaces by sputtering and etching, and to modify the properties of thin films. Unlike conventional ions, gas-cluster ions are formed from clusters of large numbers (having a typical distribution of several hundreds to several thousands with a mean value of a few thousand) of weakly bound atoms or molecules of materials that are gaseous under conditions of standard temperature and pressure (commonly oxygen, nitrogen, or an inert gas such as argon, for example, but any condensable gas can be used to generate gas-cluster ions) with each cluster sharing one or more electrical charges, and which are accelerated together through large electric potential differences (on the order of from about 3 kV to about 70 kV or more) to have high total energies. After gas-cluster ions have been formed and accelerated, their charge states may be altered or become altered (even neutralized) by collisions with other cluster ions, other neutral clusters, or residual background gas particles, and thus they may fragment or may be induced to fragment into smaller cluster ions or into monomer ions and/or into neutralized smaller clusters and neutralized monomers, but the resulting cluster ions, neutral clusters, and monomer ions and neutral monomers tend to retain the relatively high velocities and energies that result from having been accelerated through large electric potential differences, with the accelerated gas-cluster ion energy being distributed over the fragments.

Because the energies of individual atoms within a large gas-cluster ion are very small, typically a few eV to some tens of eV, the atoms penetrate through, at most, only a few atomic layers of a target surface during impact. This shallow penetration (typically a few nanometers to about ten nanometers, depending on the beam acceleration) of the impacting atoms means all of the energy carried by the entire cluster ion is consequently dissipated in an extremely small volume in a very shallow surface layer during a time period of less than a microsecond. This differs from conventional ion beams where the penetration into the material is sometimes several hundred nanometers, producing changes and material modification deep below the surface of the material. Because of the high total energy of the gas-cluster ion and extremely small interaction volume, the deposited energy density at the impact site is far greater than in the case of bombardment by conventional ions. Accordingly, GCIB modification of a surface tends to produce a shallower region of atomic mixing and has thus been favored as an etching beam for depth profiling in analytical instruments. Neutral Beam processing of a surface can produce even shallower modification of a surface with less surface electrical charging.

When accelerated gas-cluster ions are fully dissociated and neutralized, the resulting neutral monomers will have energies approximately equal to the total energy of the original accelerated gas-cluster ion, divided by the numbers, N_{I}, of monomers that comprised the original gas-cluster ion at the time it was accelerated. Such dissociated neutral monomers will have energies on the order of from about 1 eV to tens or even as much as a few thousands of eV, depending on the original accelerated energy of the gas-cluster ion and the size of the gas-cluster ion at the time of acceleration.

Gas-cluster ion-beams are generated and transported for purposes of irradiating a workpiece according to known techniques. Various types of holders are known in the art for holding the object in the path of the GCIB for irradiation and for manipulating the object to permit irradiation of a multiplicity of portions of the object. Neutral Beams may be generated and transported for purposes of irradiating a workpiece according to techniques taught herein.

Various embodiments of the present invention may employ a high beam purity method and system for deriving from an accelerated gas-cluster ion-beam an accelerated neutral gas cluster and/or preferably monomer beam that can be employed for a variety of types of surface and shallow subsurface materials processing and which is capable, for many applications, of superior performance compared to conventional GCIB processing. A Neutral Beam apparatus can provide well-focused, accelerated, intense neutral monomer beams with particles having energies in the range of from about 1 eV to as much as a few thousand eV. This is an energy range in which it has heretofore been impractical with simple, relatively inexpensive apparatus to form intense neutral beams.

These accelerated Neutral Beams are generated by first forming a conventional accelerated GCIB, then partly or essentially fully dissociating it by methods and operating conditions that do not introduce impurities into the beam, then separating the remaining charged portions of the beam from the neutral portion, and subsequently using the resulting accelerated Neutral Beam for workpiece processing. Depending on the degree of dissociation of the gas-cluster ions, the Neutral Beam produced may be a mixture of neutral gas monomers and gas clusters or may essentially consist entirely or almost entirely of neutral gas monomers. It is preferred that the accelerated Neutral Beam is a fully dissociated neutral monomer beam.

An advantage of the Neutral Beams that may be produced by the methods and apparatus of this disclosure, is that they may be used to process electrically insulating materials without producing damage to the material due to charging of the surfaces of such materials by beam transported charges as commonly occurs for all ionized beams including GCIB. For example, in some applications, ions often contribute to damaging or destructive charging of thin dielectric films such as oxides, nitrides, etc. The use of Neutral Beams can enable successful beam processing of polymer, dielectric, and/or other electrically insulating or high electrical resistivity materials, coatings, and films in applications where ion beams may produce undesired side effects due to surface or other charging effects. Examples include (without limitation) processing of corrosion inhibiting coatings, and irradiation cross-linking and/or polymerization of organic films. Further examples include Neutral Beam processing of glass, polymer, and ceramic materials as well as thin film dielectric coatings such as oxides, nitrides, glasses, etc.

Another advantage of accelerated neutral monomer beams derived from an accelerated GCIB, when used in surface modification applications, is that they form a much shallower disrupted layer in the processed surface when compared even with GCIBs used in the same way.

Since the parent GCIB, from which accelerated Neutral Beams may be formed by the methods and apparatus of this disclosure, comprises ions it is readily accelerated to desired energy and is readily focused using conventional ion beam techniques. Upon subsequent dissociation and separation of the charged ions from the neutral particles, the neutral beam particles tend to retain their focused trajectories and may be transported for extensive distances with good effect.

When neutral gas clusters in a jet are ionized by electron bombardment, they become heated and/or excited. This may result in subsequent evaporation of monomers from the ionized gas cluster, after acceleration, as it travels down the beamline. Additionally, collisions of gas-cluster ions with background gas molecules in the ionizer, accelerator and beamline regions also heat and excite the gas-cluster ions and may result in additional subsequent evolution of monomers from the gas-cluster ions following acceleration. When these mechanisms for evolution of monomers are induced by electron bombardment and/or collision with background gas molecules (and/or other gas clusters) of the same gas from which the GCIB was formed, no contamination is contributed to the beam by the dissociation processes that results in evolving the monomers.

There are other mechanisms that can be employed for dissociating (or inducing evolution of monomers from) gas-cluster ions in a GCIB without introducing contamination into the beam. Some of these mechanisms may also be employed to dissociate neutral gas-clusters in a neutral gas-cluster beam. One mechanism is laser irradiation of the gas-cluster ion-beam using infra-rend or other laser energy. Laser-induced heating of the gas-cluster ions in the laser irradiated GCIB results in excitement and/or heating of the gas-cluster ions and causes subsequent evolution of monomers from the beam. Another mechanism is passing the beam through a thermally heated tube so that radiant thermal energy photons impact the gas-cluster ions in the beam. The induced heating of the gas-cluster ions by the radiant thermal energy in the tube results in excitement and/or heating of the gas-cluster ions and causes subsequent evolution of monomers from the beam. In another mechanism, crossing the gas-cluster ion-beam by a gas jet of the same gas or mixture as the source gas used in formation of the GCIB (or other non-contaminating gas) results in collisions of monomers of the gas in the gas jet with the gas clusters in the ion beam producing excitement and/or heating of the gas-cluster ions in the beam and subsequent evolution of monomers from the excited gas-cluster ions. By depending entirely on electron bombardment during initial ionization and/or collisions (with other cluster ions, or with background gas molecules of the same gas(es) as those used to form the GCIB) within the beam and/or laser or thermal radiation and/or crossed jet collisions of non-contaminating gas to produce the GCIB dissociation and/or fragmentation, contamination of the beam by collision with other materials is avoided.

As a neutral gas-cluster jet from a nozzle travels through an ionizing region where electrons are directed to ionize the clusters, a cluster may remain un-ionized or may acquire a charge state, q, of one or more charges (by ejection of electrons from the cluster by an incident electron). The ionizer operating conditions influence the likelihood that a gas cluster will take on a particular charge state, with more intense ionizer conditions resulting in greater probability that a higher charge state will be achieved. More intense ionizer conditions resulting in higher ionization efficiency may result from higher electron flux and/or higher (within limits) electron energy. Once the gas cluster has been ionized, it is typically extracted from the ionizer, focused into a beam, and accelerated by failing through an electric field. The amount of acceleration of the gas-cluster ion is readily controlled by controlling the magnitude of the accelerating electric field. Typical commercial GCIB processing tools generally provide for the gas-cluster ions to be accelerated by an electric field having an adjustable accelerating potential, V_{Acc}, typically of, for example, from about 1KV to 70 kV (but not limited to that range - V_{Acc} up to 200 kV or even more may be feasible). Thus a singly charged gas-cluster ion achieves an energy in the range of from 1 to 70 keV (or more if larger V_{Acc} is used) and a multiply charged (for example, without limitation, charge state, q=3 electronic charges) gas-cluster ion achieves an energy in the range of from 3 to 210 keV (or more for higher V_{Acc}). For other gas-cluster ion charge states and acceleration potentials, the accelerated energy per cluster is qV_{Acc} eV. From a given ionizer with a given ionization efficiency, gas-cluster ions will have a distribution of charge states from zero (not ionized) to a higher number such as, for example, 6 (or with high ionizer efficiency, even more), and the most probable and mean values of the charge state distribution also increase with increased ionizer efficiency (higher electron flux and/or energy). Higher ionizer efficiency also results in increased numbers of gas-cluster ions being formed in the ionizer. In many cases, GCIB processing throughput increases when operating the ionizer at high efficiency results in increased GCIB current. A downside of such operation is that multiple charge states that may occur on intermediate size gas-cluster ions can increase crater and/or rough interface formation by those ions, and often such effects may operate counterproductively to the intent of the processing. Thus for many GCIB surface processing recipes, selection of the ionizer operating parameters tends to involve more considerations than just maximizing beam current. In some processes, use of a "pressure cell" (see US Pat. 7,060,989, to Swenson et al.) may be employed to permit operating an ionizer at high ionization efficiency while still obtaining acceptable beam processing performance by moderating the beam energy by gas collisions in an elevated pressure "pressure cell."

With Neutral Beams there is no downside to operating the ionizer at high efficiency - in fact such operation is sometimes preferred. When the ionizer is operated at high efficiency, there may be a wide range of charge states in the gas-cluster ions produced by the ionizer. This results in a wide range of velocities in the gas-cluster ions in the extraction region between the ionizer and the accelerating electrode, and also in the downstream beam. This may result in an enhanced frequency of collisions between and among gas-cluster ions in the beam that generally results in a higher degree of fragmentation of the largest gas-cluster ions. Such fragmentation may result in a redistribution of the cluster sizes in the beam, skewing it toward the smaller cluster sizes. These cluster fragments retain energy in proportion to their new size (N) and so become less energetic while essentially retaining the accelerated velocity of the initial unfragmented gas-cluster ion. The change of energy with retention of velocity following collisions has been experimentally verified (as for example reported in Toyoda, N. et al., "Cluster size dependence on energy and velocity distributions of gas-cluster ions after collisions with residual gals," Nucl. Instr. & Meth. in Phys. Research B 257 (2007), pp 662-665). Fragmentation may also result in redistribution of charges in the cluster fragments. Some uncharged fragments likely result and multi-charged gas-cluster ions may fragment into several charged gas-cluster ions and perhaps some uncharged fragments. It is understood by the inventors that design of the focusing fields in the ionizer and the extraction region may enhance the focusing of the smaller gas-cluster ions and monomer ions to increase the likelihood of collision with larger gas-cluster ions in the beam extraction region and in the downstream beam, thus contributing to the dissociation and/or fragmenting of the gas-cluster ions.

In an embodiment of the present invention, background gas pressure in the ionizer, acceleration region, and beamline may optionally be arranged to have a higher pressure than is normally utilized for good GCIB transmission. This can result in additional evolution of monomers from gas-cluster ions (beyond that resulting from the heating and/or excitement resulting from the initial gas cluster ionization event). Pressure may be arranged so that gas-cluster ions have a short enough mean-free-path and a long enough flight path between ionizer and workpiece that they must undergo multiple collisions with background gas molecules.

For a homogeneous gas-cluster ion containing N monomers and having a charge state of q and which has been accelerated through an electric field potential drop of V_{Acc} volts, the cluster will have energy of approximately qV_{Acc}/N_{I} eV per monomer, where N_{I} is the number of monomers in the cluster ion at the time of acceleration. Except for the smallest gas-cluster ions, a collision of such an ion with a background gas monomer of the same gas as the cluster source gas will result in additional deposition of approximately qV_{Acc}/N_{I} eV into the gas-cluster ion. This energy is relatively small compared to the overall gas-cluster ion energy (qV_{Acc}) and generally results in excitation or heating of the cluster and in subsequent evolution of monomers from the cluster. It is believed that such collisions of larger clusters with background gas seldom fragment the cluster but rather heats and/or excites it to result in evolution of monomers by evaporation or similar mechanisms. Regardless of the source of the excitation that results in the evolution of a monomer or monomers from a gas-cluster ion, the evolved monomer(s) have approximately the same energy per particle, qV_{Acc}/N_{I} eV, and retain approximately the same velocity and trajectory as the gas-cluster ion from which they have evolved. When such monomer evolutions occur from a gas-cluster ion, whether they result from excitation or heating due to the original ionization event, a collision, or radiant heating, the charge has a high probability of remaining with the larger residual gas-cluster ion. Thus after a sequence of monomer evolutions, a large gas-cluster ion may be reduced to a cloud of co-traveling monomers with perhaps a smaller residual gas-cluster ion (or possibly several if fragmentation has also occurred). The co-traveling monomers following the original beam trajectory all have approximately the same velocity as that of the original gas-cluster ion and each has energy of approximately qV_{Acc}/N_{I} eV. For small gas-cluster ions, the energy of collision with a background gas monomer is likely to completely and violently dissociate the small gas cluster and it is uncertain whether in such cases the resulting monomers continue to travel with the beam or are ejected from the beam.

Prior to the GCIB reaching the workpiece, the remaining charged particles (gas-cluster ions, particularly small and intermediate size gas-cluster ions and some charged monomers, but also including any remaining large gas-cluster ions) in the beam are separated from the neutral portion of the beam, leaving only a Neutral Beam for processing the workpiece.

In typical operation, the fraction of power in the neutral beam components relative to that in the full (charged plus neutral) beam delivered at the processing target is in the range of from about 5% to 95%, so by the separation methods and apparatus it is possible to deliver that portion of the kinetic energy of the full accelerated charged beam to the target as a Neutral Beam.

The dissociation of the gas-cluster ions and thus the production of high neutral monomer beam energy is facilitated by 1) Operating at higher acceleration voltages. This increases qV_{Acc}/N for any given cluster size. 2) Operating at high ionizer efficiency. This increases qV_{Acc}/N for any given cluster size by increasing q and increases cluster-ion on cluster-ion collisions in the extraction region due to the differences in charge states between clusters; 3) Operating at a high ionizer, acceleration region, or beamline pressure or operating with a gas jet crossing the beam, or with a longer beam path, all of which increase the probability of background gas collisions for a gas-cluster ion of any given size; 4) Operating with laser irradiation or thermal radiant heating of the beam, which directly promote evolution of monomers from the gas-cluster ions; and 5) Operating at higher nozzle gas flow, which increases transport of gas, clustered and perhaps unclustered into the GCIB trajectory, which increases collisions resulting in greater evolution of monomers.

Measurement of the Neutral Beam cannot be made by current measurement as is convenient for gas-cluster ion-beams. A Neutral Beam power sensor is used to facilitate dosimetry when irradiating a workpiece with a Neutral Beam. The Neutral Beam sensor is a thermal sensor that intercepts the beam (or optionally a known sample of the beam). The rate of rise of temperature of the sensor is related to the energy flux resulting from energetic beam irradiation of the sensor. The thermal measurements must be made over a limited range of temperatures of the sensor to avoid errors due to thermal re-radiation of the energy incident on the sensor. For a GCIB process, the beam power (watts) is equal to the beam current (amps) times V_{Acc}, the beam acceleration voltage. When a GCIB irradiates a workpiece for a period of time (seconds), the energy (joules) received by the workpiece is the product of the beam power and the irradiation time. The processing effect of such a beam when it processes an extended area is distributed over the area (for example, cm²). For ion beams, it has been conveniently conventional to specify a processing dose in terms of irradiated ions/cm², where the ions are either known or assumed to have at the time of acceleration an average charge state, q, and to have been accelerated through a potential difference of, V_{Acc} volts, so that each ion carries an energy of V_{Acc} eV (an eV is approximately 1.6 x 10⁻¹⁹ joule). Thus an ion beam dose for an average charge state, q, accelerated by V_{Acc} and specified in ions/cm² corresponds to a readily calculated energy dose expressible in joules/cm². For an accelerated Neutral Beam derived from an accelerated GCIB as utilized herein, the value of q at the time of acceleration and the value of V_{Acc} is the same for both of the (later- formed and separated) charged and uncharged fractions of the beam. The power in the two (neutral and charged) fractions of the GCIB divides proportional to the mass in each beam fraction. Thus for the accelerated Neutral Beam as employed herein, when equal areas are irradiated for equal times, the energy dose (joules/cm²) deposited by the Neutral Beam is necessarily less than the energy dose deposited by the full GCIB. By using a thermal sensor to measure the power in the full GCIB P_{G} and that in the Neutral Beam P_{N} (which is commonly found to be about 5% to 95% that of the full GCIB) it is possible to calculate a compensation factor for use in the Neutral Beam processing dosimetry. When P_{N} is aP_{G}, then the compensation factor is, k = 1/a. Thus if a workpiece is processed using a Neutral Beam derived from a GCIB, for a time duration is made to be k times greater than the processing duration for the full GCIB (including charged and neutral beam portions) required to achieve a dose of ions/cm², then the energy doses deposited in the workpiece by both the Neutral Beam and the full GCIB are the same (though the results may be different due to qualitative differences in the processing effects due to differences of particle sizes in the two beams.) As used herein, a Neutral Beam process dose compensated in this way is sometimes described as having an energy/cm² equivalence of a dose of ions/cm².

Use of a Neutral Beam derived from a gas-cluster ion-beam in combination with a thermal power sensor for dosimetry in many cases has advantages compared with the use of the full gas-cluster ion-beam or an intercepted or diverted portion, which inevitably comprises a mixture of gas-cluster ions and neutral gas clusters and/or neutral monomers, and which is conventionally measured for dosimetry purposes by using a beam current measurement. Some advantages are as follows:
1) The dosimetry can be more precise with the Neutral Beam using a thermal sensor for dosimetry because the total power of the beam is measured. With a GCIB employing the traditional beam current measurement for dosimetry, only the contribution of the ionized portion of the beam is measured and employed for dosimetry. Minute-to-minute and setup-to-setup changes to operating conditions of the GCIB apparatus may result in variations in the fraction of neutral monomers and neutral clusters in the GCIB These variations can result in process variations that may be less controlled when the dosimetry is done by beam current measurement,
2) With a Neutral Beam, any material may be processed, including highly insulating materials and other materials that may be damaged by electrical charging effects, without the necessity of providing a source of target neutralizing electrons to prevent workpiece charging due to charge transported to the workpiece by an ionized beam. When employed with conventional GCIB, target neutralization to reduce charging is seldom perfect, and the neutralizing electron source itself often introduces problems such as workpiece heating, contamination from evaporation or sputtering in the electron source, etc. Since a Neutral Beam does not transport charge to the workpiece, such problems are reduced.
3) There is no necessity for an additional device such as a large aperture high strength magnet to separate energetic monomer ions from the Neutral Beam. In the case of conventional GCIB the risk of energetic monomer ions (and other small cluster ions) being transported to the workpiece, where they penetrate producing deep damage, is significant and an expensive magnetic filter is routinely required to separate such particles from the beam. In the case of the Neutral Beam apparatus, the separation of all ions from the beam to produce the Neutral Beam inherently removes all monomer ions.

In the following description, for simplification, item numbers from earlier-described figures may appear in subsequently-described figures without discussion. Likewise, items discussed in relation to earlier figures may appear in subsequent figures without item numbers or additional description. In such cases items with like numbers are like items and have the previously-described features and functions, and illustration of items without item numbers shown in the present figure refer to like items having the same functions as the like items illustrated in earlier-discussed numbered figures.

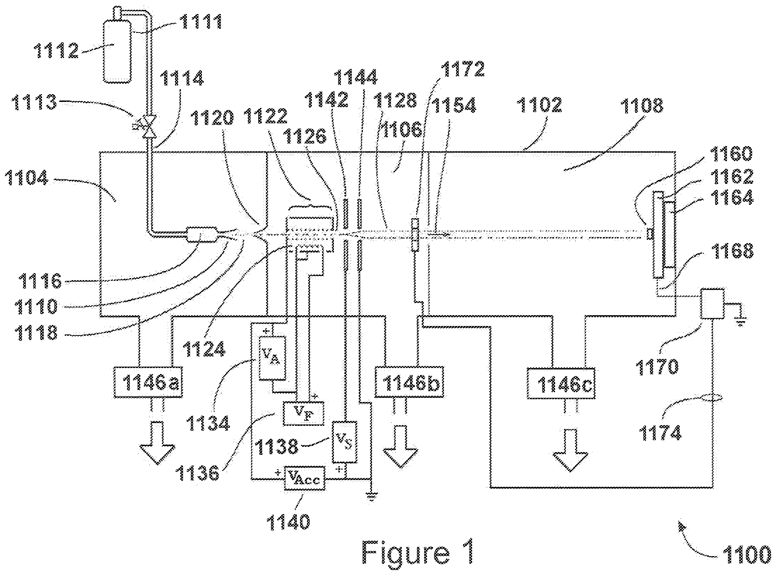

Reference is now made to Figures 1, which shows a schematic configuration for a GCIB processing apparatus 1100. A low-pressure vessel 1102 has three fluidly connected chambers: a nozzle chamber 1104, an ionization/acceleration chamber 1106, and a processing chamber 1108. The three chambers are evacuated by vacuum pumps 1146a, 1146b, and 1146c, respectively. A pressurized condensable source gas 1112 (for example argon) stored in a gas storage cylinder 1111 flows through a gas metering valve 1113 and a feed tube 1114 into a stagnation chamber 1116. Pressure (typically a few atmospheres) in the stagnation chamber 1116 results in ejection of gas into the substantially lower pressure vacuum through a nozzle 1110, resulting in formation of a supersonic gas jet 1118. Cooling, resulting from the expansion in the jet, causes a portion of the gas jet 1118 to condense into clusters, each consisting of from several to several thousand weakly bound atoms or molecules. A gas skimmer aperture 1120 is employed to control flow of gas into the downstream chambers by partially separating gas molecules that have not condensed into a cluster jet from the cluster jet. Excessive pressure in the downstream chambers can be detrimental by interfering with the transport of gas-cluster ions and by interfering with management of the high voltages that may be employed for beam formation and transport. Suitable condensable source gases 1112 include, but are not limited to argon and other condensable noble gases, nitrogen, carbon dioxide, oxygen, and many other gases and/or gas mixtures. After formation of the gas clusters in the supersonic gas jet 1118, at least a portion of the gas clusters are ionized in an ionizer 1122 that is typically an electron impact ionizer that produces electrons by thermal emission from one or more incandescent filaments 1124 (or from other suitable electron sources) and accelerates and directs the electrons, enabling them to collide with gas clusters in the gas jet 1118. Electron impacts with gas clusters eject electrons from some portion of the gas clusters, causing those clusters to become positively ionized. Some clusters may have more than one electron ejected and may become multiply ionized. Control of the number of electrons and their energies after acceleration typically influences the number of ionizations that may occur and the ratio between multiple and single ionizations of the gas clusters. A suppressor electrode 1142, and grounded electrode 1144 extract the cluster ions from the ionizer exit aperture 1126, accelerate them to a desired energy (typically with acceleration potentials of from several hundred V to several tens ofkV), and focuses them to form a GCIB 1128. As will be indicated below, the suppressor electrode 1142 is not strictly required and may be omitted. The region that the GCIB 1128 traverses between the ionizer exit aperture 126 and the suppressor electrode 1142 is referred to as the extraction region. The axis (determined at the nozzle 1110), of the supersonic gas jet 1118 containing gas clusters is substantially the same as the axis 1154 of the GCIB 1128. Filament power supply 1136 provides filament voltage V_{f} to heat the ionizer filament 1124. Anode power supply 1134 provides anode voltage V_{A} to accelerate thermoelectrons emitted from filament 1124 to cause the thermoelectrons to irradiate the cluster-containing gas jet 1118 to produce cluster ions. A suppression power supply 1138 supplies suppression voltage V_{S} (on the order of several hundred to a few thousand volts) to bias suppressor electrode 1142 (when employed). When suppressor electrode 1142 is omitted, as described below, the suppression power supply 1138 may also be omitted. Accelerator power supply 1140 supplies acceleration voltage V_{Acc} to bias the ionizer 1122 with respect to suppressor electrode 1142 and grounded electrode 1144 so as to result in a total GCIB acceleration potential equal to V_{Acc}. Suppressor electrode 1142 serves to extract ions from the ionizer exit aperture 1126 of ionizer 1122 and to prevent undesired electrons from entering the ionizer 1122 from downstream, and to form a focused GCIB 1128.

A workpiece 1160, which may (for example) be a medical device, a semiconductor material, an optical element, or other workpiece to be processed by GCIB processing, is held on a workpiece holder 1162, which disposes the workpiece in the path of the GCIB 1128. The workpiece holder is attached to but electrically insulated from the processing chamber 1108 by an electrical insulator 1164. Thus, GCIB 1128 striking the workpiece 1160 and the workpiece holder 1162 flows through an electrical lead 1168 to a dose processor 1170. A beam gate 1172 controls transmission of the GCIB 1128 along axis 1154 to the workpiece 1160. The beam gate 1172 typically has an open state and a closed state that is controlled by a linkage 1174 that may be (for example) electrical, mechanical, or electromechanical. Dose processor 1170 controls the open/closed state of the beam gate 1172 to manage the GCIB dose received by the workpiece 1160 and the workpiece holder 1162. In operation, the dose processor 1170 opens the beam gate 1172 to initiate GCIB irradiation of the workpiece 1160. Dose processor 1170 typically integrates GCIB electrical current arriving at the workpiece 1160 and workpiece holder 1162 to calculate an accumulated GCIB irradiation dose. At a predetermined dose, the dose processor 1170 closes the beam gate 1172, terminating processing when the predetermined dose has been achieved.

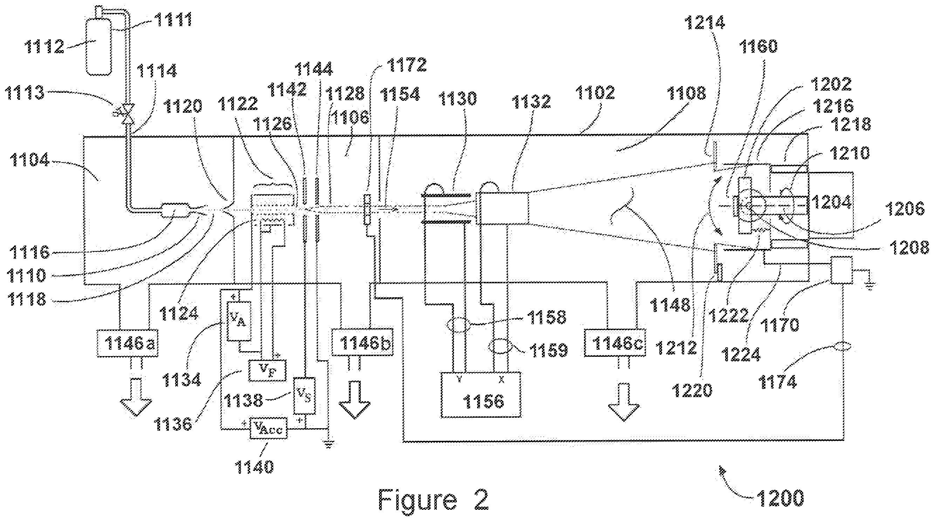

Figure 2 shows a schematic illustrating elements of another GCIB processing apparatus 1200 for workpiece processing using a GCIB, wherein scanning of the ion beam and manipulation of the workpiece is employed. A workpiece 1160 to be processed by the GCIB processing apparatus 1200 is held on a workpiece holder 1202, disposed in the path of the GCIB 1128. In order to accomplish uniform processing of the workpiece 1160, the workpiece holder 1202 is designed to manipulate workpiece 1160, as may be required for uniform processing.

Any workpiece surfaces that are non-planar, for example, spherical or cup-like, rounded, irregular, or other un-flat configuration, may be oriented within a range of angles with respect to the beam incidence to obtain optimal GCIB processing of the workpiece surfaces. The workpiece holder 1202 can be fully articulated for orienting all non-planar surfaces to be processed in suitable alignment with the GCIB 1128 to provide processing optimization and uniformity. More specifically, when the workpiece 1160 being processed is non-planar, the workpiece holder 1202 may be rotated in a rotary motion 1210 and articulated in articulation motion 1212 by an articulation/rotation mechanism 1204. The articulation/rotation mechanism 1204 may permit 360 degrees of device rotation about longitudinal axis 1206 (which is coaxial with the axis 1154 of the GCIB 1128) and sufficient articulation about an axis 1208 perpendicular to axis 1206 to maintain the workpiece surface to within a desired range of beam incidence.

Under certain conditions, depending upon the size of the workpiece 1160, a scanning system may be desirable to produce uniform irradiation of a large workpiece. Although often not necessary for GCIB processing, two pairs of orthogonally oriented electrostatic scan plates 1130 and 1132 may be utilized to produce a raster or other scanning pattern over an extended processing area. When such beam scanning is performed, a scan generator 1156 provides X-axis scanning signal voltages to the pair of scan plates 1132 through lead pair 1159 and Y-axis scanning signal voltages to the pair of scan plates 1130 through lead pair 1158. The scanning signal voltages are commonly triangular waves of different frequencies that cause the GCIB 1128 to be converted into a scanned GCIB 1148, which scans the entire surface of the workpiece 1160. A scanned beam-defining aperture 1214 defines a scanned area. The scanned beam-defining aperture 1214 is electrically conductive and is electrically connected to the low-pressure vessel 1102 wall and supported by support member 1220. The workpiece holder 1202 is electrically connected via a flexible electrical lead 1222 to a faraday cup 1216 that surrounds the workpiece 1160 and the workpiece holder 1202 and collects all the current passing through the defining aperture 1214. The workpiece holder 1202 is electrically isolated from the articulation/rotation mechanism 1204 and the faraday cup 1216 is electrically isolated from and mounted to the low-pressure vessel 1102 by insulators 1218. Accordingly, all current from the scanned GCIB 1148, which passes through the scanned beam-defining aperture 1214 is collected in the faraday cup 1216 and flows through electrical lead 1224 to the dose processor 1170. In operation, the dose processor 1170 opens the beam gate 1172 to initiate GCIB irradiation of the workpiece 1160. The dose processor 1170 typically integrates GCIB electrical current arriving at the workpiece 1160 and workpiece holder 1202 and faraday cup 1216 to calculate an accumulated GCIB irradiation dose per unit area. At a predetermined dose, the dose processor 1170 closes the beam gate 1172, terminating processing when the predetermined dose has been achieved. During the accumulation of the predetermined dose, the workpiece 1160 may be manipulated by the articulation/rotation mechanism 1204 to ensure processing of all desired surfaces.

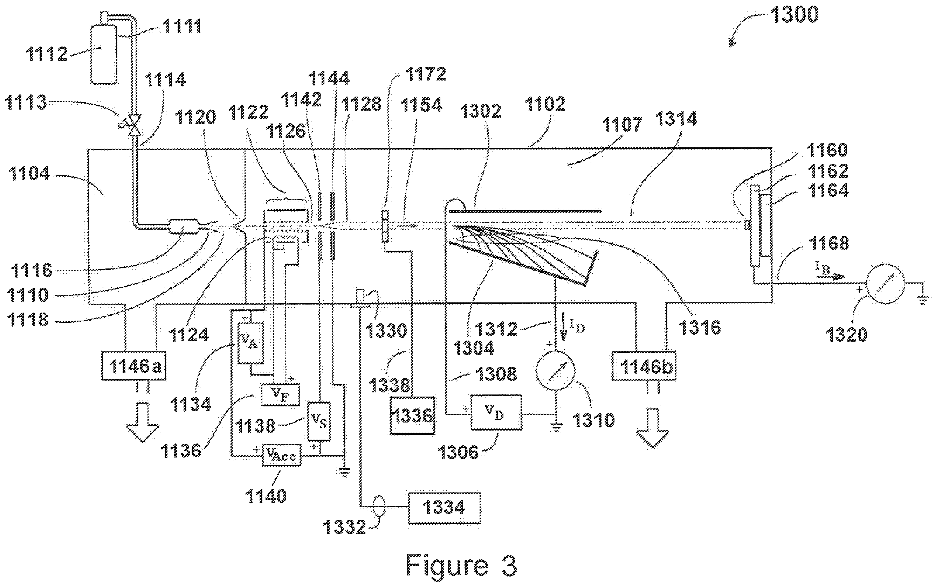

Figure 3 is a schematic of a Neutral Beam processing apparatus 1300 of an exemplary type that may be employed for Neutral Beam processing according to embodiments of the invention. It uses electrostatic deflection plates to separate the charged and uncharged portions of a GCIB, A beamline chamber 1107 encloses the ionizer and accelerator regions and the workpiece processing regions. The beamline chamber 1107 has high conductance and so the pressure is substantially uniform throughout. A vacuum pump 1146b evacuates the beamline chamber 1107. Gas flows into the beamline chamber 1107 in the form of clustered and unclustered gas transported by the gas jet 1118 and in the form of additional unclustered gas that leaks through the gas skimmer aperture 1120. A pressure sensor 1330 transmits pressure data from the beamline chamber 1107 through an electrical cable 1332 to a pressure sensor controller 1334, which measures and displays pressure in the beamline chamber 1107. The pressure in the beamline chamber 1107 depends on the balance of gas flow into the headline chamber 1107 and the pumping speed of the vacuum pump 1146b. By selection of the diameter of the gas skimmer aperture 1120, the flow of source gas 1112 through the nozzle 1110, and the pumping speed of the vacuum pump 1146b, the pressure in the beamline chamber 1107 equilibrates at a pressure, PB, determined by design and by nozzle flow. The beam flight path from grounded electrode 1144 to workpiece holder 162, is for example, 100 cm. By design and adjustment PB may be approximately 6 x 10⁻⁵ torr (8 x 10⁻³ pascal). Thus the product of pressure and beam path length is approximately 6 x 10⁻³ torr-cm (0,8 pascal-cm) and the gas target thickness for the beam is approximately 1,94 x 10¹⁴ gas molecules per cm², which is observed to be effective for dissociating the gas-cluster ions in the GCIB 1128. V_{Acc} may be for example 30kV and the GCIB 1128 is accelerated by that potential. A pair of deflection plates (1302 and 1304) is disposed about the axis 1154 of the GCIB 1128. A deflector power supply 1306 provides a positive deflection voltage V_{D} to deflection plate 1302 via electrical lead 1308. Deflection plate 1304 is connected to electrical ground by electrical lead 1312 and through current sensor/display 1310. Deflector power supply 1306 is manually controllable. V_{D} may be adjusted from zero to a voltage sufficient to completely deflect the ionized portion 1316 of the GCIB 1128 onto the deflection plate 1304 (for example a few thousand volts). When the ionized portion 1316 of the GCIB 1128 is deflected onto the deflection plate 1304, the resulting current, I_{D} flows through electrical lead 1312 and current sensor/display 1310 for indication. When V_{D} is zero, the GCIB 1128 is undeflected and travels to the workpiece 1160 and the workpiece holder 1162. The GCIB beam current I_{B} is collected on the workpiece 1160 and the workpiece holder 1162 and flows through electrical lead 1168 and current sensor/display 1320 to electrical ground. I_{B} is indicated on the current sensor/display 1320. A beam gate 1172 is controlled through a linkage 1338 by beam gate controller 1336. Beam gate controller 1336 may be manual or may be electrically or mechanically timed by a preset value to open the beam gate 1172 for a predetermined interval. In use, V_{D} is set to zero and the beam current, I_{B}, striking the workpiece holder is measured. Based on previous experience for a given GCIB process recipe, an initial irradiation time for a given process is determined based on the measured current, I_{B}. V_{D} is increased until all measured beam current is transferred from I_{B} to I_{D} and I_{D} no longer increases with increasing V_{D}. At this point a Neutral Beam 1314 comprising energetic dissociated components of the initial GCIB 1128 irradiates the workpiece holder 1162. The beam gate 1172 is then closed and the workpiece 1160 placed onto the workpiece holder 1162 by conventional workpiece loading means (not shown). The beam gate 1172 is opened for the predetermined initial radiation time. After the irradiation interval, the workpiece may be examined and the processing time adjusted as necessary to calibrate the duration of Neutral Beam processing based on the measured GCIB beam current I_{B}. Following such a calibration process, additional workpieces may be processed using the calibrated exposure duration.

The Neutral Beam 1314 contains a repeatable fraction of the initial energy of the accelerated GCIB 1128. The remaining ionized portion 1316 of the original GCIB 1128 has been removed from the Neutral Beam 1314 and is collected by the grounded deflection plate 1304. The ionized portion 1316 that is removed from the Neutral Beam 1314 may include monomer ions and gas-cluster ions including intermediate size gas-cluster ions. Because of the monomer evaporation mechanisms due to cluster heating during the ionization process, intra-beam collisions, background gas collisions, and other causes (all of which result in erosion of clusters) the Neutral Beam substantially consists of neutral monomers, while the separated charged particles are predominately cluster ions. The inventors have confirmed this by suitable measurements that include re-ionizing the Neutral Beam and measuring the charge to mass ratio of the resulting ions. As will be shown below, certain superior process results are obtained by processing workpieces using this Neutral Beam.

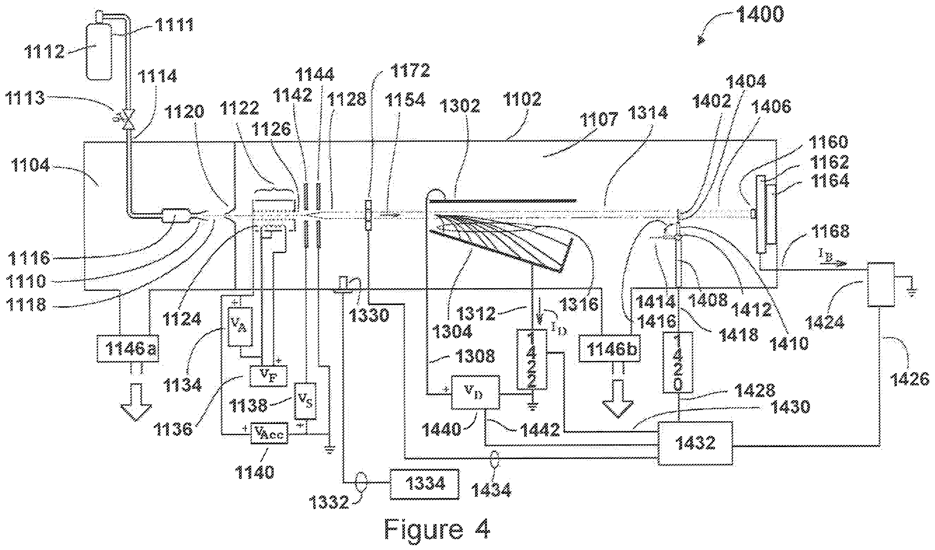

Figure 4 is a schematic of a Neutral Beam processing apparatus 1400 as may, for example, be used in generating Neutral Beams as may be employed in embodiments of the invention. It uses a thermal sensor for Neutral Beam measurement. A thermal sensor 1402 attaches via low thermal conductivity attachment 1404 to a rotating support arm 1410 attached to a pivot 1412. Actuator 1408 moves thermal sensor 1402 via a reversible rotary motion 1416 between positions that intercept the Neutral Beam 1314 or GCIB 1128 and a parked position indicated by 1414 where the thermal sensor 1402 does not intercept any beam. When thermal sensor 1402 is in the parked position (indicated by 1414) the GCIB 1128 or Neutral Beam 1314 continues along path 1406 for irradiation of the workpiece 1160 and/or workpiece holder 1162. A thermal sensor controller 1420 controls positioning of the thermal sensor 1402 and performs processing of the signal generated by thermal sensor 1402. Thermal sensor 1402 communicates with the thermal sensor controller 1420 through an electrical cable 1418. Thermal sensor controller 1420 communicates with a dosimetry controller 1432 through an electrical cable 1428. A beam current measurement device 1424 measures beam current I_{B} flowing in electrical lead 1168 when the GCIB 1128 strikes the workpiece 1160 and/or the workpiece holder 1162. Beam current measurement device 1424 communicates a beam current measurement signal to dosimetry controller 1432 via electrical cable 1426. Dosimetry controller 1432 controls setting of open and closed states for beam gate 1172 by control signals transmitted via linkage 1434. Dosimetry controller 1432 controls deflector power supply 1440 via electrical cable 1442 and can control the deflection voltage V_{D} between voltages of zero and a positive voltage adequate to completely deflect the ionized portion 1316 of the GCIB 1128 to the deflection plate 1304. When the ionized portion 1316 of the GCIB 1128 strikes deflection plate 1304, the resulting current I_{D} is measured by current sensor 1422 and communicated to the dosimetry controller 1432 via electrical cable 1430. In operation dosimetry controller 1432 sets the thermal sensor 1402 to the parked position 1414, opens beam gate 1172, and sets V_{D} to zero so that the full GCIB 1128 strikes the workpiece holder 1162 and/or workpiece 1160. The dosimetry controller 1432 records the beam current I_{B} transmitted from beam current measurement device 1424. The dosimetry controller 1432 then moves the thermal sensor 1402 from the parked position 1414 to intercept the GCIB 1128 by commands relayed through thermal sensor controller 1420. Thermal sensor controller 1420 measures the beam energy flux of GCIB 1128 by calculation based on the heat capacity of the sensor and measured rate of temperature rise of the thermal sensor 1402 as its temperature rises through a predetermined measurement temperature (for example 70 degrees C) and communicates the calculated beam energy flux to the dosimetry controller 1432 which then calculates a calibration of the beam energy flux as measured by the thermal sensor 1402 and the corresponding beam current measured by the beam current measurement device 1424. The dosimetry controller 1432 then parks the thermal sensor 1402 at parked position 1414, allowing it to cool and commands application of positive V_{D} to deflection plate 1302 until the entire current I_{D} due to the ionized portion of the GCIB 1128 is transferred to the deflection plate 1304. The current sensor 1422 measures the corresponding I_{D} and communicates it to the dosimetry controller 1432. The dosimetry controller also moves the thermal sensor 1402 from parked position 1414 to intercept the Neutral Beam 1314 by commands relayed through thermal sensor controller 420. Thermal sensor controller 420 measures the beam energy flux of the Neutral Beam 1314 using the previously determined calibration factor and the rate of temperature rise of the thermal sensor 1402 as its temperature rises through the predetermined measurement temperature and communicates the Neutral Beam energy flux to the dosimetry controller 1432. The dosimetry controller 1432 calculates a neutral beam fraction, which is the ratio of the thermal measurement of the Neutral Beam 1314 energy flux to the thermal measurement of the full GCIB 1128 energy flux at sensor 1402. Under typical operation, a neutral beam fraction of from about 5% to about 95% is achieved. Before beginning processing, the dosimetry controller 1432 also measures the current, I_{D}, and determines a current ratio between the initial values of I_{B} and I_{D}. During processing, the instantaneous I_{D} measurement multiplied by the initial I_{B}/I_{D} ratio may be used as a proxy for continuous measurement of the I_{B} and employed for dosimetry during control of processing by the dosimetry controller 1432. Thus the dosimetry controller 1432 can compensate any beam fluctuation during workpiece processing, just as if an actual beam current measurement for the full GCIB 1128 were available. The dosimetry controller uses the neutral beam fraction to compute a desired processing time for a particular beam process. During the process, the processing time can be adjusted based on the calibrated measurement of I_{D} for correction of any beam fluctuation during the process.

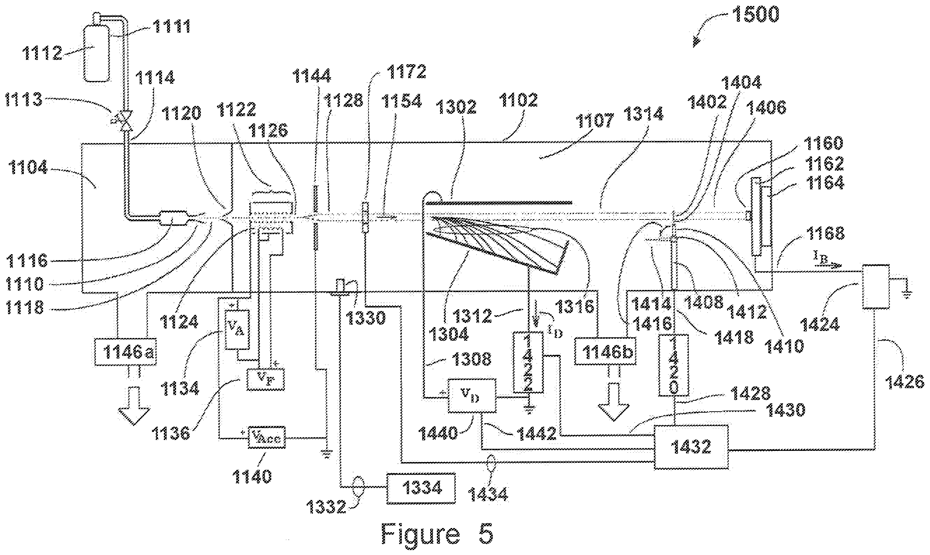

Figure 5 is a schematic of a somewhat simplified Neutral Beam processing apparatus 1500 as may, for example, be used in generating deflected, aligned, or scanned Neutral Beams as may be employed in embodiments of the invention. It is identical to the Neutral Beam processing apparatus 1400 shown previously, with a simplification to the beam extraction and acceleration scheme employed at the exit of the ionizer. The simplification of Neutral Beam processing apparatus 1500 is omission of the suppression power supply 1138 and the suppressor electrode 1142 (both shown in Figure 4, Neutral Beam processing apparatus 1400). Referring again to Figure 5, without the suppressor electrode, ground electrode 1144 serves to extract ions from the ionizer 1122 and to accelerate the gas-cluster ions and to form the GCIB 1128. Accelerator power supply 1140 supplies acceleration voltage V_{Acc} to bias the ionizer 1122 with respect to grounded electrode 1144 so as to result in a total GCIB acceleration potential equal to V_{Acc}. By omitting the suppressor electrode 1142 (Fig. 4) and its bias power supply 1138 (Fig.4), the Neutral Beam processing system 1500 is somewhat simplified in comparison to the Neutral Beam processing system 1400, at the expense of somewhat heavier current loading of the accelerator power supply 1140 that provides V_{ACC}.

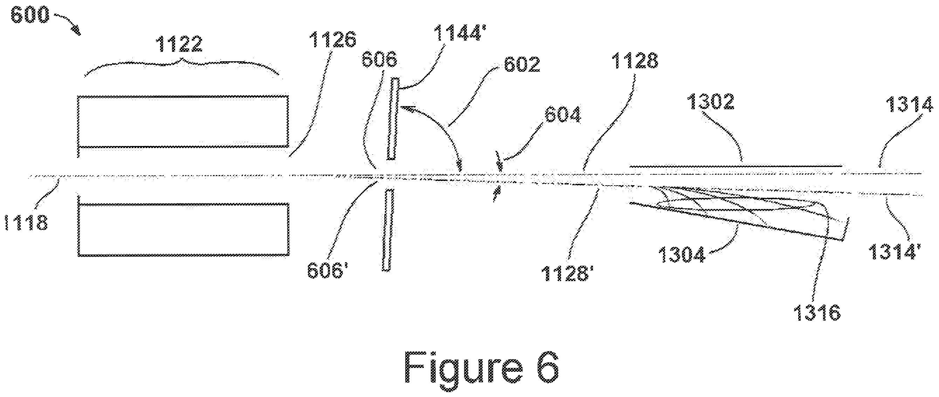

Figure 6 is a schematic 600 showing a concept underlying embodiments of the invention that permit mechanical steering of the Neutral Beam in a Neutral Beam apparatus similar to the simplified Neutral Beam processing apparatus 1500 shown previously in Figure 5. Referring again to Figure 6, a portion of a simplified Neutral Beam processing apparatus is shown. A gas jet 1118 enters ionizer 1122 where it is ionized to form a gas-cluster ion-beam travelling along a path 606 (or 606') which are extracted from the ionizer exit aperture 1126 by the electric field between ionizer exit aperture 1126 and ground electrode 1144'. Although not shown, ionizer 1122 and ionizer exit aperture 1126 are biased as shown in previous Figure 5. Ground electrode 1144' is grounded as was ground electrode 1144 in previous Figure 5. Referring again to Figure 6, ground electrode 1144' is similar to previously shown ground electrode 1144, except it is tilted slightly with respect to the path of gas-cluster ions 606 by a tilt angle 602 that is less than 90 degrees. The distortion of the electric field between ionizer exit aperture 1126 and the ground electrode 1144' causes deflection of the gas-cluster ions that would otherwise follow path 606 onto path 606' with a resulting beam deflection angle 604 that is greater than zero degrees. By varying the tilt angle 602, the beam deflection angle 604 is varied, with 604 increasing as 602 decreases. Referring again to Figure 6, as the tilt angle 602 decreases from 90 degrees, the beam deflection angle 604 of the GCIB increases and the GCIB becomes GCIB 1128' deflected from original GCIB 1128. The tilt angle 602 is preferably less than 90 degrees and greater than 70 degrees with respect to the initial path. In the drift space between the ground electrode 1144' and the pair of deflection plates (1302 and 1304), dissociation of the deflected accelerated GCIB 1128' proceeds. Although not shown in Figure 6, the pair of deflection plates (1302 and 1304), are biased as shown previously in Figure 5. Referring again to Figure 6, as GCIB 1128' plus dissociated neutral particles pass between the pair of deflection plates 1302 and 1304, the ionized portion 1316 of the GCIB 1128' is deflected onto the deflection plate 1304 and a deflected neutral beam 1314' that is free of charged particles is transmitted. The path of the deflected neutral beam 1314' is deflected from the path of neutral beam 1314 that occurs when the tilt angle 602 of the ground electrode 1144' is 90 degrees.

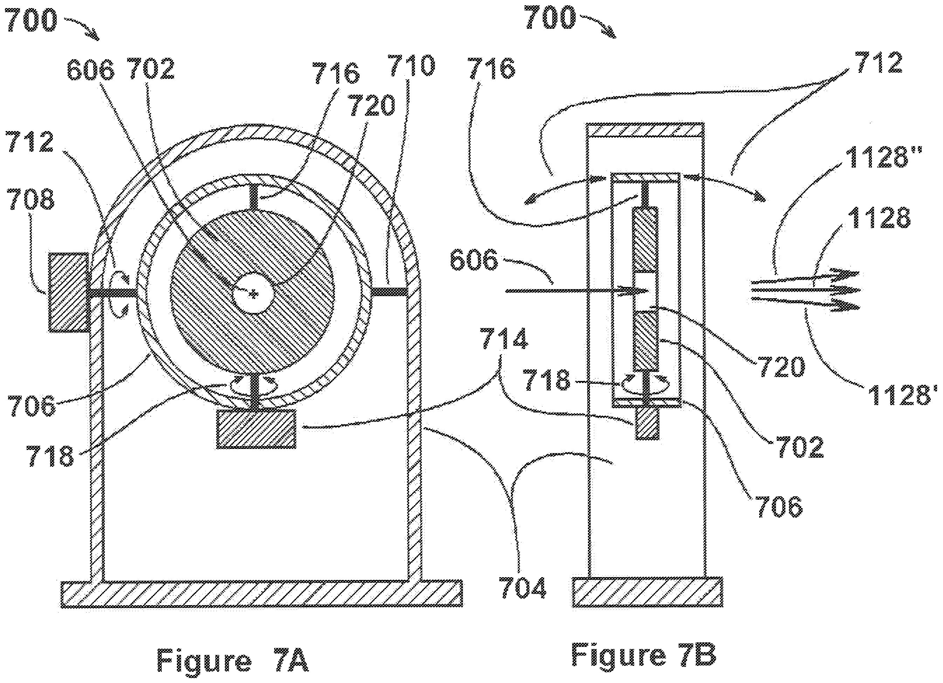

Figures 7A and 7B are two orthogonal views of a tiltable ground electrode assembly 700 that is compatible with the simplified Neutral Beam processing apparatus 1500 shown in Figure 5.

Figure 7A is a sectional view looking along the direction of the path of gas-cluster ions 606 and looking away from the ionizer and towards the downstream workpiece. A tiltable ground electrode 702 is mounted in a gimbal arrangement in a tiltable ground electrode support 704. Tiltable ground electrode 702 can be tilted about a first tilt axis 710, which may be a horizontal axis and also about as second tilt axis 716, which may be a vertical axis. Axes 710 and 716 are preferably but not necessarily orthogonal to one another. A first tilt actuator 708 provides a first rotary motion 712 to tilt the gimbal ring 706 and the tiltable ground electrode about the first tilt axis 710, A second tilt actuator 714 provides a second rotary motion 718 to tilt the tiltable ground electrode about the second tilt axis 716 relative to the gimbal ring 706. The first tilt actuator 708 and the second tilt actuator 714 may be actuated independently or simultaneously to tilt about either or both of the tilt axes 710 and 716. Tilt actuators 708 and 714 may either or both be either manually actuated or actuated by a controllable system such as a stepper motor under electronic control. When manually actuated the compound tilt angle resulting from the compound rotary motions 712 and 718 result in a particular tilt of the tiltable ground electrode 702. When actuated by controlled stepper motors (or the equivalent) the rotary motions 712 and 718 may be periodic and produce a continuously varying compound tilting of the tiltable ground electrode 702 for beam scanning.

Figure 7B is a sectional view orthogonal to the view of 7A and is shown in section. The path of the gas-cluster ions 606 (having been extracted from an upstream ionizer not shown in this view) enters the ground electrode aperture 720 and departs as an accelerated GCIB. 1128. Depending on tilt angles resulting from rotary motion 712, the accelerated GCIB may also depart as deflected GCIBs 1128' or 1128" (for examples). Depending on tilt angles resulting from rotary motion 718, the accelerated GCIB may depart in the downstream direction of GCIB. 1128, 1128', or 1128" but also deflected into or out of the plane of the paper in a compound beam deflection angle. When the rotary motions 712 and 718 are periodic and produce a continuously varying compound tilting of the tiltable ground electrode 702 the beam is scanned. When the entering gas-cluster ions 606 are slightly misaligned with a desired downstream beam pathway indicated by the pathway of GCIB 1128, small angular adjustments to tiltable ground electrode 702 can be employed to bring the exiting beam into alignment with desired GCIB 1128 pathway.

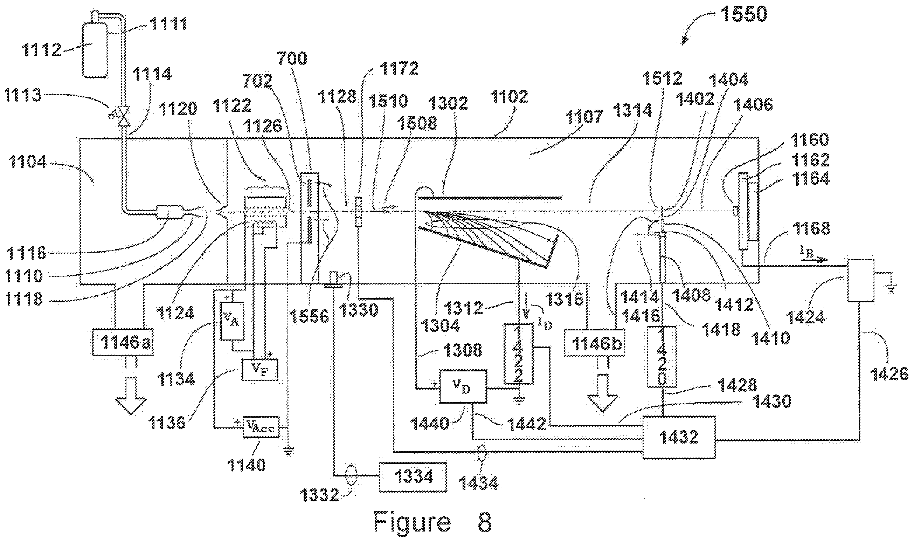

Figure 8 is a schematic of a Neutral Beam processing apparatus 1550 as may, for example, be used in generating Neutral Beams as may be employed in embodiments of the invention. A tiltable ground electrode assembly 700 contains a tiltable ground electrode 702. Compound tilt motions 1556 permit steering the downstream GCIB 1128 along a desired pathway 1510 or other pathways (1508 for example) to align the downstream beam path as desired. A downstream neutral beam sensor, for example a thermal sensor 1402 having a small sensitive area 1512 can be used to align the downstream Neutral Beam 1314 toward a workpiece 1160 or other selected spot.

Thus, a method and apparatus for controlling the direction of a Neutral Beam derived from a GCIB, includes an acceleration electrode having an aperture encircling a beam path for a GCIB portion of the beam and a mounting apparatus for the electrode enabling tilting of the electrode in polar directions relative to the beam path. The electrode is mounted for tilting along two axes that are generally orthogonal to the beam path and the axes may be orthogonal to each other. Tilting of the electrode may be precisely electrically controlled to provide beam scanning and beam alignment and otherwise provide deflection to the GCIB portion of the beam. A thermal sensor may be included in a Neutral Beam portion for measuring beam power. The area of the sensor exposable to the Neutral Beam may be limited as a means of beam alignment.

Although the invention has been described primarily in the figures as methods and apparatus for alignment of a Neutral Beam, it is understood by the inventors that the use of repetitive deflections (resulting from tilt of the electrode about the axes) of the resulting Neutral Beam can be used to scan the Neutral Beam over an extended region, and the invention is intended to also include such uses.

Although the invention has been described with respect to various embodiments, it should be realized that this invention is also capable of a wide variety of further and other embodiments within the scope of the invention.

## Claims

1. An apparatus for controlling a direction and alignment of a Neutral Beam derived from a gas-cluster ion-beam, the apparatus comprising:
a. an apparatus (1100) for forming a gas cluster ion beam (1128) having an initial axis determined at a gas jet nozzle (1110) in an ion source (1126) that has an exit aperture encircling the initial axis and an accelerating electrode (1144', 702) spaced from the exit aperture, said accelerating electrode having an aperture (720) encircling the initial axis;
wherein, the accelerating electrode and its aperture (720) are configured to be tilted at a first tilt angle along a first tilt axis, with respect to the initial axis of the gas-cluster ion-beam (1128);
further wherein, the accelerating electrode is configured to be electrically biased with respect to the ion source (1126) to accelerate and focus the gas-cluster ion-beam (1128) in a region between the ion source exit aperture (702) and the accelerating electrode aperture;
even further wherein the accelerating electrode and its aperture are configured to be tilted at a second tilt angle along a second tilt axis with respect to the initial path of the gas-cluster ion-beam (1128) and the resulting deflection is a compound deflection , wherein the first and second tilt axes are distinct and
still further wherein, the first tilt angle and the second tilt angle enable alignment and result in a deflection of the gas-cluster ion-beam (1128) away from the initial axis along a first deflected path;
b. a drift space for the deflected gas-cluster ion-beam (1128), wherein dissociation of gas-cluster ions in the accelerated and focused gas-cluster ion-beam (1128) occurs, producing accelerated and focused neutral particles; and
c. means (1302, 1304) for separating ions from neutral particles to remove ions from the deflected beam path, so that the accelerated neutral particles follow the deflected beam path (1154) as a Neutral Beam.

2. The apparatus (1100) of claim 1, wherein the first tilt angle is less than 90 degrees and, optionally,
wherein the first tilt angle is greater than 70 degrees.

3. The apparatus (1100) of claim 1, wherein the first tilt angle is controllably variable and the resulting deflection of the gas-cluster ion-beam (1128) is variable.

4. The apparatus (1100) of claim 1, wherein the second tilt angle is
(a) less than 90 degrees and greater than 70 degrees; or
(b) controllably variable and the resulting deflection of the gas-cluster ion-beam (1128) is variable

5. The apparatus (1100) of claim 1, wherein the first tilt angle and the second tilt angle are each controllably variable and, optionally, further comprising means for controlling the first and second tilt angles to produce a raster-scanned Neutral Beam.

6. A method for producing a deflection and alignment of a Neutral Beam derived from a gas-cluster ion-beam (1128) having an initial axis determined at a gas jet nozzle (1126) in an ion source (1126) that has an exit aperture encircling the initial axis, the method comprising the steps:
a. encircling the initial axis with an aperture (720) in an accelerating electrode spaced from the exit aperture;
b. electrically biasing the accelerating electrode with respect to the ion source (1126) to provide an accelerated and focused gas-cluster ion-beam in an acceleration region between the ion source exit aperture and the accelerating electrode aperture (720);
c. first tilting the accelerating electrode and its aperture (720) at a first tilt angle, along a first tilt axis, with respect to the initial axis of the gas-cluster ion-beam, wherein the gas-cluster ion-beam is deflected away from the initial axis along a first deflected path;
d. second tilting the accelerating electrode and its aperture (720) at a second tilt angle, along a second tilt axis distinct from the first tilt axis, with respect to the initial axis of the gas-cluster ion-beam producing a resulting deflection that is a compound deflection;
e. providing a drift space for the deflected gas-cluster ion-beam, wherein dissociation of gas-cluster ions in the accelerated and focused gas-cluster ion-beam occurs, producing accelerated and focused neutral particles; and
f. separating ions from neutral particles to remove ions from the deflected beam path (1154), permitting the accelerated and focused neutral particles to follow the deflected beam path (1154) as a Neutral Beam.

7. The method of claim 6, wherein the first tilt angle is
(a) less than 90 degrees and greater than 70 degrees; or
(b) controllably varied and the resulting deflection of the gas-cluster ion-beam is varied.

8. The method of claim 6, wherein the second tilt angle is
(a) less than 90 degrees and greater than 70 degrees with respect to the initial axis; or
(b) controllably varied and the resulting deflection of the gas-cluster ion-beam is varied.

9. The method of claim 6, wherein the first tilt angle and the second tilt angle are each controllably varied and the first and second tilt axes are distinct.

10. The method of claim 6, wherein the first and second tilt axes are perpendicular to each other and to the initial axis.

11. The method of claim 10 further comprising the step of variably controlling the first or second tilt angles to produce
(a) a scanned Neutral Beam; or
(b) a scanned Neutral Beam scanned in two dimensions.

## Patentansprüche

1. Vorrichtung zur Steuerung einer Richtung und Ausrichtung eines von einem Gas-Cluster-Ionenstrahl stammenden Neutralstrahls, wobei die Vorrichtung Folgendes umfasst:
a. eine Vorrichtung (1100) zum Bilden eines Gas-Cluster-Ionenstrahls (1128) mit einer Anfangsachse, die an einer Gasstrahldüse (1110) in einer Ionenquelle (1126) mit einer die Anfangsachse einkreisenden Austrittsblende und einer von der Austrittsblende beabstandeten Beschleunigungselektrode (1144', 702) bestimmt wird, wobei die Beschleunigungselektrode eine die Anfangsachse einkreisende Blende (720) aufweist;
wobei die Beschleunigungselektrode und ihre Blende (720) dazu konfiguriert sind, um einen ersten Neigungswinkel entlang einer ersten Neigungsachse in Bezug auf die Anfangsachse des Gas-Cluster-Ionenstrahls (1128) geneigt zu werden;
wobei weiter die Beschleunigungselektrode dazu konfiguriert ist, in Bezug auf die Ionenquelle (1126) elektrisch vorgespannt zu werden, um den Gas-Cluster-Ionenstrahl (1128) in einem Bereich zwischen der Ionenquellen-Austrittsblende (702) und der Beschleunigungselektrodenblende zu beschleunigen und zu bündeln;
wobei noch weiter die Beschleunigungselektrode und ihre Blende dazu konfiguriert sind, um einen zweiten Neigungswinkel entlang einer zweiten Neigungsachse in Bezug auf die Anfangsbahn des Gas-Cluster-Ionenstrahls (1128) geneigt zu werden und es sich bei der resultierenden Ablenkung um eine zusammengesetzte Ablenkung handelt, wobei die erste und die zweite Neigungsachse verschieden sind, und
wobei noch weiter der erste Neigungswinkel und der zweite Neigungswinkel eine Ausrichtung ermöglichen und in einer Ablenkung des Gas-Cluster-Ionenstrahls (1128) weg von der Anfangsachse entlang einer ersten abgelenkten Bahn resultieren;
b. einen Triftraum für den abgelenkten Gas-Cluster-Ionenstrahl (1128), in dem die Dissoziation von Gas-Cluster-Ionen in dem beschleunigten und gebündelten Gas-Cluster-Ionenstrahl (1128) stattfindet, wobei beschleunigte und gebündelte neutrale Partikel erzeugt werden; und
c. Mittel (1302, 1304) zum Abscheiden von Ionen von neutralen Partikeln, um Ionen aus der abgelenkten Strahlbahn zu entfernen, sodass die beschleunigten neutralen Partikel der abgelenkten Strahlbahn (1154) als Neutralstrahl folgen.

2. Vorrichtung (1100) nach Anspruch 1, wobei der erste Neigungswinkel weniger als 90 Grad beträgt, und
wobei optional der erste Neigungswinkel mehr als 70 Grad beträgt.

3. Vorrichtung (1100) nach Anspruch 1, wobei der erste Neigungswinkel steuerbar variabel ist und die resultierende Ablenkung des Gas-Cluster-Ionenstrahls (1128) variabel ist.

4. Vorrichtung (1100) nach Anspruch 1, wobei der zweite Neigungswinkel
(a) weniger als 90 Grad und mehr als 70 Grad beträgt; oder
(b) steuerbar variabel ist und die resultierende Ablenkung des Gas-Cluster-Ionenstrahls (1128) variabel ist.

5. Vorrichtung (1100) nach Anspruch 1, wobei der erste Neigungswinkel und der zweite Neigungswinkel jeweils steuerbar variabel sind, und optional weiter umfassend Mittel zum Steuern des ersten und des zweiten Neigungswinkels, um einen gerasterten Neutralstrahl zu erzeugen.

6. Verfahren zur Erzeugung einer Ablenkung und Ausrichtung eines Neutralstrahls, der von einem Gas-Cluster-Ionenstrahl (1128) stammt, der eine an einer Gasstrahldüse (1126) in einer Ionenquelle (1126) mit einer die Anfangsachse einkreisenden Austrittsblende bestimmte Anfangsachse aufweist, wobei das Verfahren Folgende Schritte umfasst:
a. Einkreisen der Anfangsachse mit einer Blende (720) in einer von der Austrittsblende beabstandeten Beschleunigungselektrode;
b. elektrisch Vorspannen der Beschleunigungselektrode in Bezug auf die Ionenquelle (1126), um einen beschleunigten und gebündelten Gas-Cluster-Ionenstrahl in einem Beschleunigungsbereich zwischen der Ionenquellen-Austrittsblende und der Beschleunigungselektrodenbelende (720) bereitzustellen;
c. erstes Neigen der Beschleunigungselektrode und ihrer Blende (720) um einen ersten Neigungswinkel entlang einer ersten Neigungsachse in Bezug auf die Anfangsachse des Gas-Cluster-Ionenstrahls, wobei der Gas-Cluster-Ionenstrahl entlang einer ersten abgelenkten Bahn von der Anfangsachse weg abgelenkt wird;
d. zweites Neigen der Beschleunigungselektrode und ihrer Blende (720) um einen zweiten Neigungswinkel entlang einer von der ersten Neigungsachse verschiedenen zweiten Neigungsachse in Bezug auf die Anfangsachse des Gas-Cluster-Ionenstrahls, wobei eine resultierende Ablenkung erzeugt wird, bei der es sich um eine zusammengesetzte Ablenkung handelt;
b. Bereitstellen eines Triftraums für den abgelenkten Gas-Cluster-Ionenstrahl, in dem die Dissoziation von Gas-Cluster-Ionen in dem beschleunigten und gebündelten Gas-Cluster-Ionenstrahl stattfindet, wobei beschleunigte und gebündelte neutrale Partikel erzeugt werden; und
f. Abscheiden von Ionen von neutralen Partikeln, um Ionen aus der abgelenkten Strahlbahn (1154) zu entfernen, wobei den beschleunigten und gebündelten neutralen Partikeln ermöglicht wird, der abgelenkten Strahlbahn (1154) als Neutralstrahl zu folgen.

7. Verfahren nach Anspruch 6, wobei der erste Neigungswinkel
(a) weniger als 90 Grad und mehr als 70 Grad beträgt; oder
(b) steuerbar variiert wird und die resultierende Ablenkung des Gas-Cluster-Ionenstrahls variiert wird.

8. Verfahren nach Anspruch 6, wobei der zweite Neigungswinkel
(a) weniger als 90 Grad und mehr als 70 Grad in Bezug auf die Anfangsachse beträgt; oder
(b) steuerbar variiert wird und die resultierende Ablenkung des Gas-Cluster-Ionenstrahls variiert wird.

9. Verfahren nach Anspruch 6, wobei der erste Neigungswinkel und der zweite Neigungswinkel jeweils steuerbar variiert werden und die erste und die zweite Neigungsachse verschieden sind.

10. Verfahren nach Anspruch 6, wobei die erste und die zweite Neigungsachse zueinander und zur Anfangsachse senkrecht sind.

11. Verfahren nach Anspruch 10, weiter umfassend den Schritt des variablen Steuerns des ersten oder des zweiten Neigungswinkels, um Folgendes zu erzeugen:
(a) einen Neutral-Rasterstrahl; oder
(b) einen in zwei Dimensionen gerasterten Neutral-Rasterstrahl.

## Revendications

1. Appareil pour le contrôle d'une direction et d'un alignement d'un faisceau neutre issu d'un faisceau d'ions d'amas gazeux, l'appareil comprenant :
a. un appareil (1100) pour former un faisceau d'ions d'amas gazeux (1128) ayant un axe initial déterminé au niveau d'une buse à jet de gaz (1110) dans une source d'ions (1126) qui a une ouverture de sortie encerclant l'axe initial et une électrode d'accélération (1144', 702) espacée de l'ouverture de sortie, ladite électrode d'accélération ayant une ouverture (720) encerclant l'axe initial ;
dans lequel l'électrode d'accélération et son ouverture (720) sont configurées pour être inclinées à un premier angle d'inclinaison le long d'un premier axe d'inclinaison, par rapport à l'axe initial du faisceau d'ions d'amas gazeux (1128) ;
dans lequel en outre l'électrode d'accélération est configurée pour être électriquement polarisée par rapport à la source d'ions (1126) pour accélérer et cibler le faisceau d'ions d'amas gazeux (1128) dans une région entre l'ouverture de sortie (702) de la source d'ions et l'ouverture de l'électrode d'accélération ;
dans lequel encore en outre l'électrode d'accélération et son ouverture sont configurées pour être inclinées à un second angle d'inclinaison le long d'un second axe d'inclinaison par rapport au trajet initial du faisceau d'ions d'amas gazeux (1128) et la déviation résultante est une déviation composite, les premier et second axes d'inclinaison étant distincts, et
dans lequel encore en outre le premier angle d'inclinaison et le second angle d'inclinaison permettent un alignement et conduisent à une déviation du faisceau d'ions d'amas gazeux (1128) à l'écart de l'axe initial le long d'un premier trajet dévié ;
b. un espace de glissement pour le faisceau d'ions d'amas gazeux (1128) dévié, une dissociation d'ions d'amas gazeux ayant lieu dans le faisceau d'ions d'amas gazeux (1128) accéléré et ciblé, produisant des particules neutres accélérées et ciblées ; et
c. des moyens (1302, 1304) pour la séparation d'ions à partir de particules neutres pour retirer des ions à partir du trajet de faisceau dévié, de sorte que les particules neutres accélérées suivent le trajet de faisceau dévié (1154) en tant que faisceau neutre.

2. Appareil (1100) de la revendication 1, dans lequel le premier angle d'inclinaison est inférieur à 90 degrés et, facultativement, dans lequel le premier angle d'inclinaison est supérieur à 70 degrés.

3. Appareil (1100) de la revendication 1, dans lequel le premier angle d'inclinaison est variable de manière contrôlée et la déviation résultante du faisceau d'ions d'amas gazeux (1128) est variable.

4. Appareil (1100) de la revendication 1, dans lequel le second angle d'inclinaison est
(a) inférieur à 90 degrés et supérieur à 70 degrés ; ou
(b) variable de manière contrôlée et la déviation résultante du faisceau d'ions d'amas gazeux (1128) est variable.

5. Appareil (1100) de la revendication 1, dans lequel le premier angle d'inclinaison et le second angle d'inclinaison sont chacun variables de manière contrôlée et, facultativement, comprenant en outre des moyens pour le contrôle des premier et second angles d'inclinaison pour produire un faisceau neutre à balayage tramé.

6. Procédé pour la production d'une déviation et d'un alignement d'un faisceau neutre issu d'un faisceau d'ions d'amas gazeux (1128) ayant un axe initial déterminé au niveau d'une buse à jet de gaz (1126) dans une source d'ions (1126) qui a une ouverture de sortie encerclant l'axe initial, le procédé comprenant les étapes suivantes consistant à :
a. encercler l'axe initial avec une ouverture (720) dans une électrode d'accélération espacée de l'ouverture de sortie ;
b. polariser électriquement l'électrode d'accélération par rapport à la source d'ions (1126) pour fournir un faisceau d'ions d'amas gazeux accéléré et ciblé dans une région d'accélération entre l'ouverture de sortie de la source d'ions et l'ouverture (720) de l'électrode d'accélération ;
c. incliner en premier lieu l'électrode d'accélération et son ouverture (720) à un premier angle d'inclinaison, le long d'un premier axe d'inclinaison, par rapport à l'axe initial du faisceau d'ions d'amas gazeux, le faisceau d'ions d'amas gazeux étant dévié à l'écart de l'axe initial le long d'un premier trajet dévié ;
d. incliner en second lieu l'électrode d'accélération et son ouverture (720) à un second angle d'inclinaison, le long d'un second axe d'inclinaison distinct du premier axe d'inclinaison, par rapport à l'axe initial du faisceau d'ions d'amas gazeux, produisant une déviation résultante qui est une déviation composite ;
e. fournir un espace de glissement pour le faisceau d'ions d'amas gazeux dévié, une dissociation d'ions d'amas gazeux ayant lieu dans le faisceau d'ions d'amas gazeux accéléré et ciblé, produisant des particules neutres accélérées et ciblées ; et
f. séparer des ions à partir de particules neutres pour retirer des ions à partir du trajet de faisceau dévié (1154), permettant aux particules neutres accélérées et ciblées de suivre le trajet de faisceau dévié (1154) en tant que faisceau neutre.

7. Procédé de la revendication 6, dans lequel le premier angle d'inclinaison est
(a) inférieur à 90 degrés et supérieur à 70 degrés ; ou
(b) variable de manière contrôlée et l'on fait varier la déviation résultante du faisceau d'ions d'amas gazeux.

8. Procédé de la revendication 6, dans lequel le second angle d'inclinaison est
(a) inférieur à 90 degrés et supérieur à 70 degrés par rapport à l'axe initial ; ou
(b) variable de manière contrôlée et l'on fait varier la déviation résultante du faisceau d'ions d'amas gazeux.

9. Procédé de la revendication 6, dans lequel on fait varier le premier angle d'inclinaison et le second angle d'inclinaison chacun de manière contrôlée et les premier et second axes d'inclinaison sont distincts.

10. Procédé de la revendication 6, dans lequel les premier et second axes d'inclinaison sont perpendiculaires l'un à l'autre et à l'axe initial.

11. Procédé de la revendication 10, comprenant en outre l'étape consistant à contrôler de manière variable les premier ou second angles d'inclinaison pour produire
(a) un faisceau neutre balayé ; ou
(b) un faisceau neutre balayé, balayé en deux dimensions.
